# EUROPEAN PATENT APPLICATION

(11) **EP 4 571 561 A1**
(43) Date of publication of application: **18.06.2025**
(21) Application number: 24208325.1
(22) Date of filing: 23.10.2024
(51) Int. Cl.: G06F 30/15, B64G 7/00, G06F 30/20

(54) **TIERED MULTI-PAYLOAD MISSION SIMULATION**

(30) Priority: 12.12.2023 US 202318536596
(71) Applicant: Loft Orbital Technologies S.A.S., 31000 Toulouse (FR)
(72) Inventor: McLachlan, Caleb, 31000 Toulouse (FR); Vaujour, Pierre-Damien, 31000 Toulouse (FR); Bremond, Lucas, 31000 Toulouse (FR)
(74) Representative: Meissner Bolte Nürnberg

(57) **Abstract**

A tiered multi-payload simulation system manages a series of simulations before deploying multiple entity-specific payloads on a single spacecraft. Each entity-specific payload can be validated by at least two different simulations before being deployed on the spacecraft. A first simulation applied to a payload may be an abstracted version of a second simulation applied to the payload. Entities with different operation objectives request different resources, specific contexts to use a given resource (e.g., time, orientation of the spacecraft, terrestrial events, etc.). Entities may iteratively simulate their payload using the abstracted version before providing the payload to a spacecraft operator for simulation using the second, high-fidelity simulation. The spacecraft operator may apply a resource optimization simulation to determine an operating scheme for executing multiple payloads on a single spacecraft.

## Description

This disclosure relates generally to spaceborne missions and in particular, simulating multi-payload rideshare missions.

### BACKGROUND

Conventional systems for spaceborne missions may be simulated by a spacecraft operator that controls not only the spacecraft but the design of third-party software applications that are installed on the spacecraft. Limited control is afforded to the third-party entity owning the software application when the third-party themselves do not own the spacecraft. When available, providing a simulation that simulates an entire spacecraft and its operations may be done in-person or remotely. In an in-person embodiment, an entity may visit a secured facility where the simulator is available to test whether their software application is compatible with the spacecraft. This may be inefficient if the entity must revisit the facility multiple times between iterations of developing their software application. In a remote embodiment, a copy of the simulation package may be provided that is equipped with access restrictions for security purposes (e.g., to prevent proprietary operations of the spacecraft from being readily accessed by entities who are third parties to the spacecraft provider). However, this method is burdened by storage and communication bandwidth consumption challenges (e.g., providing a large simulation remotely consumes a large communication bandwidth).

### SUMMARY

A tiered multi-payload simulation system described herein allows entities to simulate their software applications without the inefficiencies or the resource consumption of providing a full simulation package. The tiered multi-payload simulation system allows entities access to an abstracted version of the full simulation, which is also referred to as a high-fidelity simulation. The abstracted simulation can save bandwidth and memory resources due to its smaller size relative to the high-fidelity simulation. An entity's client device does not necessarily need to download and store the high-fidelity simulation to perform tests to verify that its entity application would be compatible with a particular spacecraft. Moreover, the abstracted simulation can increase the efficiency of the testing process for an entity by allowing the entity to iterate on the design of their entity application flexibly rather than restrict the entity to iterating only after being able to access a copy of the high-fidelity simulation at a secured site (e.g., the spacecraft operator's facility), which can be time and cost consuming (e.g., for entities who cannot travel easily to the spacecraft operator's facility).

Additionally, the tiered multi-payload simulation system includes the high-fidelity simulation that enables a spacecraft operator to verify that each individual payload does indeed operate compatibly with the spacecraft. This verification may be necessary because the spacecraft operator is not necessarily the entity, and thus, cannot guarantee the entity has verified their payload before providing the payload to the spacecraft operator for incorporation onto the operator's spacecraft. Because the operator cannot guarantee that the behavior of a given entity application is not malicious, the high-fidelity simulation may simulate the entity application in a sandbox environment to improve security for the system on which the high-fidelity simulation is executed.

In one embodiment, the tiered multi-payload simulation system receives, for each of one or more client devices, an envelope comprising simulation parameters for simulating a payload. The payload may have been previously simulated using an abstracted simulation, where the abstracted simulation includes a subset of resources for simulating a spacecraft. The tiered multi-payload simulation system validates the payloads using a high-fidelity simulation and the received envelopes. The tiered multi-payload simulation system determines, responsive to validating the payloads, an operating scheme for the payloads for an orbital rideshare mission of the spacecraft.

### BRIEF DESCRIPTION OF THE DRAWINGS

FIG. 1 is a block diagram of a system environment in which a tiered multi-payload simulation system operates, in accordance with one embodiment.
FIG. 2 is a block diagram of the tiered multi-payload simulation system of FIG. 1, in accordance with one embodiment.
FIG. 3 is a flowchart illustrating a process for simulating multiple payloads for an orbital payload rideshare mission, in accordance with one embodiment.

The figures depict various embodiments for purposes of illustration only. One skilled in the art will readily recognize from the following discussion that alternative embodiments of the structures and methods illustrated herein may be employed without departing from the principles described herein.

### DETAILED DESCRIPTION

### Overview

A tiered multi-payload simulation system manages a series of simulations before deploying multiple entity-specific payloads on a single spacecraft. Each entity-specific payload can be validated by at least two different simulations before being deployed on the spacecraft. A first simulation applied to a payload may be an abstracted version of a second simulation applied to the payload. Entities with different operation objectives request different resources, specific contexts to use a given resource (e.g., time, orientation of the spacecraft, terrestrial events, etc.). Entities that want to use their own software applications on the shared spacecraft may be required to simulate their software applications in advance before operating on the spacecraft where other entities' applications will also be operating.

Conventional methods for allowing a third-party to simulate their software on a spacecraft that is operated by a different party has challenges related to access inefficiencies (e.g., for in-person simulation) or to communication bandwidth and storage (e.g., for remote simulation). To allow an entity to simulate their software application without the inefficiencies or the resource consumption of providing a full simulation package, an abstracted version of the full simulation may be provided to the entity. The entity may access the abstracted simulation (e.g., on the cloud or download to their client device), which may include a virtualized representation of a subset of the spacecraft resources their functionality for testing. For example, an abstracted version of a full spacecraft simulation may include virtualizations of hardware elements like a camera and radio frequency (RF) communications while omitting hardware like propulsion elements for changing the trajectory of the spacecraft.

### System Architecture

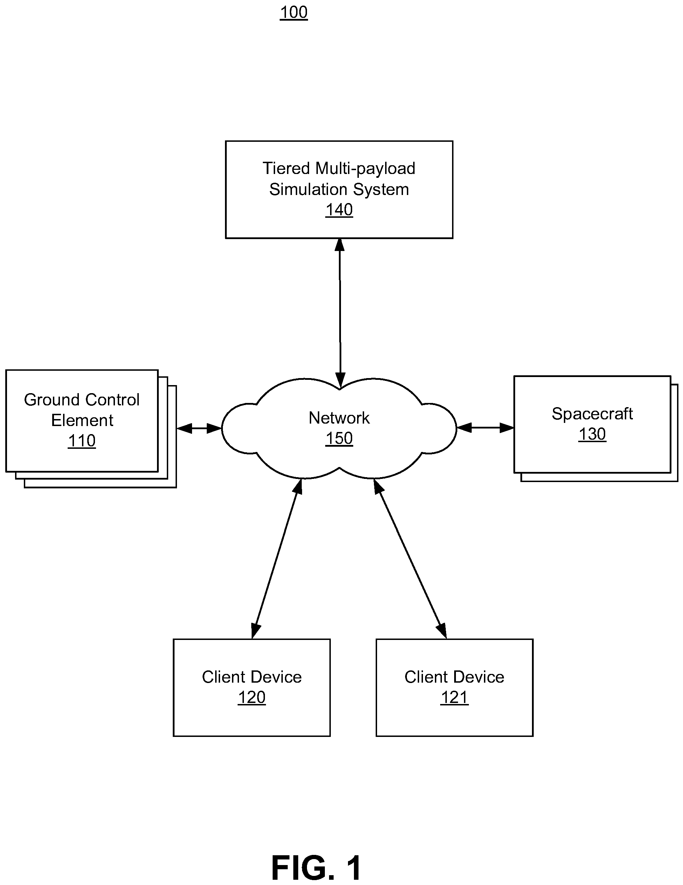

FIG. 1 is a block diagram of a system environment 100 in which a tiered multi-payload simulation system 140 operates, in accordance with one embodiment. The system environment 100 shown by FIG. 1 includes ground control elements 110, client devices 120 and 121, a spacecraft 130, the tiered multi-payload simulation system 140, and a network 150. The system environment 100 may have alternative configurations than shown in FIG. 1, including for example different, fewer, or additional components. For example, the system environment 100 may include a remote database separate from the tiered multi-payload simulation system 140 in which data for simulating payloads to be executed on the spacecraft 130 can be stored for access by the tiered multi-payload simulation system 140.

A spaceborne payload rideshare mission is a spaceborne mission in which different spaceborne missions share a single spaceborne system (e.g., a spacecraft). Separate missions can share common payload or use dedicated payload that is included on the same spaceborne system. Missions can be operated by (or operated on behalf of) different entities (e.g., customers, government agencies, etc.). Spaceborne payload rideshare missions may also be referred to as orbital payload rideshare missions. Example orbital payload rideshare missions can include missions for sampling and analysis of the radio frequency (RF) spectrum for commercial and security applications, weather sensing, imaging, or any other suitable type of spaceborne mission. A spaceborne system can include a spacecraft platform (e.g., a satellite bus) and one or more payloads.

The ground control elements 110 (e.g., terrestrial control elements) can define a ground control network (e.g., terrestrial control network). The ground control network may be a network of communication stations capable of communication with spacecraft of the constellation at various locations throughout their orbits. Each ground control element preferably includes one or more communication elements configured to communicate with spacecraft of the constellation (e.g., with the hubs, with the payloads, etc.), such as one or more wireless communication modules (e.g., configured to transmit and/or receive using the S band, X band, Ka band, UHF band, and/or any other suitable frequencies). The ground control elements can additionally include communication modules configured to communicate with client devices of the system (e.g., via the Internet, via private terrestrial communication channels, etc.) and/or with other entities (e.g., information providers, such as weather status and/or prediction providers, satellite tracking information providers, map information providers, news providers, etc.).

The ground control elements 110 can additionally or alternatively include one or more computation modules. For example, the computation modules can be configured to receive user requests, optimize constellation usage, and/or determine commands to send to the spacecraft. Example types of ground control elements 110 may be associated with (e.g., owned by, operated by, controlled by, leased by, designed by and/or for, collocated with, etc.) one or more different entities (e.g., spacecraft-based services providers, customers requesting resources of the spacecraft 130, spacecraft communications providers, government spacecraft operations agencies, etc.).

The client devices 120 and 121 may be computing devices capable of receiving user input as well as transmitting and/or receiving data via the network 150. In some embodiments, the client devices 120 and 121 are conventional computer systems, such as a desktop or a laptop computer. Alternatively, the client devices 120 and 121 may be devices having computer functionality, such as a smartphone or another suitable device. In some embodiments, the client devices 120 and 121 are configured to communicate with the tiered multi-payload simulation system 140 via a network, for example using a native application executed by the client device 120 or through an application programming interface (API) running on a native operating system of the client device 120, such as IOS^{®} or ANDROID^{™}. In some embodiments, software components of the tiered multi-payload simulation system 140, such as an abstracted simulation of the spacecraft 130, are stored and/or executed on the client devices 120 and 121. The client devices 120 and 121 may be operated by entities developing applications to be executed aboard the spacecraft 130 with other entity applications. As referred to herein, an "entity" may be a client of a spacecraft operator requesting resources on the operator's spacecraft. Examples of entities may include individuals, private organizations, educational institutions, government agencies, or any suitable collection of persons requesting access to a spaceborne rideshare mission. Although only two client devices are depicted in FIG. 1, greater or fewer client devices may be within the system environment 100.

The spacecraft 130 may be a satellite orbiting the earth. The spacecraft 130 may be in a low earth orbit (LEO) or geosynchronous earth orbit (GEO). The spacecraft 130 may be associated with an ephemeris, which can include information associated with the spacecraft's position over time. The ephemeris information can be represented by a two-line element set (TLE) and/or stored in any other suitable representation.

The spacecraft 130 can include a set of payloads and a hub. Each spacecraft can include one or more payloads: entity-specific payloads (e.g., payloads associated with an entity contracting for dedicated resources of the spacecraft 130) or generic payloads (e.g., payloads configured for general use by multiple entities). Generic payloads may be available to all users or may be permission-limited (e.g., users qualified or assigned to access payloads having a particular imaging sensor). Generic payloads can include standard payloads that were previously designed for and/or flown on other spacecrafts, available as standard designs, available commercially off-the-shelf, or a combination thereof. Each payload may be connected to a hub. The connections may be mechanical, electrical, communicative, or a combination thereof.

Payloads may include one or more hardware components (e.g., sensors, actuators, propulsion elements, experimental elements, etc.). Sensors of a payload may be imaging sensors (e.g., cameras, synthetic-aperture radar sensors, etc.). Actuators of the payload may be configured to aim and/or otherwise adjust operation of the imaging sensors (e.g., reposition a sensor, adjust elements of the sensor such as apertures, shutters, filters such as spectral filters and/or polarization filters, etc.). Experimental elements may include an experimental flight computer, experimental circuitry, control electronics for conducting experiments, or a combination thereof.

A payload can include communication elements configured to communicate with the hub and/or terrestrial elements (e.g., the ground control elements 110). Communication elements may be radio frequency (RF) elements (e.g., transmitters and receivers), optical communication elements (e.g., laser communication elements), and/or quantum-based communication elements. A payload may include computation elements that are configured to control sensors and/or communication elements. The computation elements may be configured to process commands (e.g., commands received from the hub or ground control elements). In some embodiments, one or more payloads are software-only payloads (e.g., one or more software modules executing or configured to be executed on computation elements of the payload and/or the hub). The payloads can additionally or alternatively include one or more RF sensors (e.g., radios, antennas, etc.), weather monitoring instruments, climate monitoring instruments, astrophysics instruments, cameras (e.g., optical, infrared, hyperspectral, multispectral, etc.), radar instruments, Internet of Things transmitters, computers, and/or computer circuitry, field programmable gate arrays, any suitable payload element for receiving, measuring, or processing data on the spacecraft, or a combination thereof.

In some embodiments, the payloads include elements configured to control or alter the attitude, slew rate, and/or trajectory of the spacecraft 130. In alternative embodiments, the hub or a ground control element, rather than the payloads, may provide instructions to control the attitude, slew rate, or trajectory of the spacecraft 130. The payloads may include software applications provided by entities (i.e., entity applications), where the entity applications may be executed aboard the spacecraft to fulfill service requests specified by respective entities. Entities may provide requests to the spacecraft 130, where the requests specify assets of the spacecraft 130 (e.g., a payload, a sensor, etc.), times or time intervals during which the entity is requesting the specified assets, a position of the spacecraft over Earth, an operation parameter of the spacecraft (e.g., orientation, attitude, power provision, any suitable parameter that can be controlled by the spacecraft during operation, or a combination thereof), any suitable parameter related to performing an orbital payload rideshare mission, or a combination thereof. The requests may be provided by an entity in an "envelope" to the tiered multi-payload simulation system 140. The requests in an envelope provided to the tiered multi-payload simulation system 140 may also be referred to as simulation parameters, as these requests may be used both during real time operation of the spacecraft and during simulation.

Entities may include asset specifications, spatial specifications, temporal specifications, or any suitable specification for fulfilling a service request using the spacecraft 130. Asset specifications can define which spacecraft and/or spacecraft elements (e.g., payloads, sensors, etc.) can perform a service. The asset specifications can include payload capability specifications (e.g., specifying a payload type or sensor type). The payload capability specifications can include one or more sensor parameters (e.g., wavelength(s) or spectral range to be imaged, resolution, framerate, swath, polarization, pointing accuracy, etc.) and/or payload operation parameters (e.g., payload and/or payload element settings, files to upload, etc.), such as configuration parameters and/or minimum or desired performance metrics (target performance metrics). The asset specifications may include specifications associated with hardware elements other than payloads (e.g., actuators and communication modules of the spacecraft). The asset specifications may include parameters associated with one or more astrionics elements (e.g., determination sensors such as sun sensors, star trackers, magnetometers, Earth horizon sensors, etc.) and the associated specifications can include availability (e.g., whether or not such elements are installed or available for use), alignment (e.g., direction(s) in which such elements are aligned), and/or performance (e.g., accuracy, precision, temporal resolution, etc.) metrics.

Spatial specifications may include spatial references (e.g., geographic point, region, area, volume, etc.) associated with a requested service (e.g., a point or region to be imaged by a sensor of a spacecraft). Examples of spatial specifications include target location specifications, such as geographic specifications. The spatial information (e.g., target location) can be specified using geographic coordinates (e.g., latitude, longitude, and/or altitude), can be selected or drawn on a map (e.g., world map, regional map, etc.), can be specified relative to another location or other reference (e.g., stationary reference, mobile reference, etc.), can be specified based on one or more events (e.g., location of an event of interest, such as a news, meteorological, and/or geological event), can be specified based on relative positions of multiple objects (e.g., spatial specifications satisfied if payload is in Earth's shadow), or any other suitable matter.

Temporal specifications can include a specific time point. For example, temporal specifications specify that a service should be performed at or near a specified time point or time interval. Temporal specifications can specify that a service be performed as soon as possible (or as soon as possible after a specific condition occurs). Temporal services can link a service to a trigger condition, where criteria associated with desired timing are provided by an entity. Trigger conditions can include occurrence of an event of interest (e.g., news, weather event, etc.). Temporal specifications can be for a single time or interval, or for a periodic set of times or intervals (e.g., specifying a time of day, a day of the week, a time relative to sunrise or sunset, etc.). For periodic specifications, the request can be a request to perform the service once at any of the times or during any of the intervals (e.g., preferably performed sooner rather than later), or can be a recurring request (e.g., a request to repeat service performance at each of the times or intervals, or at a subset thereof).

The specifications can additionally or alternatively include specifications associated with the spacecraft and/or sensor position relative to the target location and/or flight configuration (e.g., off-nadir angle) can include specifications associated with other objects in the environment (e.g., associated with the position of the sun, such as a solar elevation angle, position of the moon, etc.), can include specifications associated with known and/or predicted weather conditions (e.g., cloud cover, temperature at a target location, etc.), can include specifications associated with financial aspects of service performance (e.g., price charged to the requesting entity for the spacecraft to perform the requested service and/or acquire rights for the requested service, etc.), or any suitable specification associated with the performance of the service request and/or associated with conditions at or near the target location.

Envelopes may contain requests by entities that are based on specifications (e.g., for the set of services requested), ephemerides (e.g., of the constellation and/or a subset of the spacecraft), communication considerations (e.g., times at which ground station elements can communicate with the spacecraft, quantities of data expected to be sent or received from the spacecraft, etc.), spacecraft resources (e.g., power generation or storage states, such as a state of charge of a battery, spacecraft attitude control rates (slew rates), heat generation or dissipation requirements, etc.), constraints associated with spacecraft configuration (e.g., arising from elements of the hub, from other payloads of the spacecraft, etc.), or any suitable information. Envelopes may be based on authorization permissions or asset restrictions, such as contractual or legal permissions or restrictions. For example, an entity may have exclusive rights to a particular asset within a particular geographic region (e.g., when outside the geographic region, the asset may be available for other entities' requests). Requests in envelopes may be associated with an entity priority or request priority (e.g., rule-based priorities). Requests in envelopes may also be associated with environmental information such as weather forecast information, cloud cover information, or any suitable information based on environmental conditions.

A hub of the spacecraft 130 can control operation of the spacecraft 130, coordinate operation of the payload(s) on the spacecraft 130, or a combination thereof. The hub may include one or more spacecraft buses. The hub may include an interface module that is an interface (e.g., communication, mechanical, and/or electrical interface) between elements of the spacecraft (e.g., between the bus and one or more of the payloads). The interface module can facilitate use of payloads, buses, or a combination thereof in a spacecraft.

The hub may measure and/or control spacecraft operation (e.g., measuring and/or controlling spacecraft attitude or trajectory). The hub may include one or more astrionics modules (e.g., sun sensors, star trackers, magnetometers, Earth horizon sensors, global navigation satellite system receivers, etc.). For example, the hub can include attitude control mechanisms (e.g., reaction wheels, thrusters, control moment gyroscopes, etc.) and/or trajectory control mechanisms (e.g., propulsive devices), such as trajectory control mechanisms used for orbital station-keeping and/or orbit alteration.

The hub may control spacecraft communication with ground control elements. For example, terrestrial communication is performed via the hub, and the hub authorizes communication with any terrestrial element. The hub can include one or more wireless communication modules, such as those configured to communicate (e.g., transmit and/or receive) using the X band, Ka band, ultra high frequency (UHF) band, any other suitable frequencies, or a combination thereof. Communication modules of the payloads may additionally or alternatively communicate with the ground control elements, other terrestrial elements, any other suitable elements, or a combination thereof.

The spacecraft 130 may be one of a constellation (or other collection) of spacecrafts. The constellation may be a homogeneous constellation (e.g., including only identical or substantially identical spacecraft) or a heterogeneous constellation (e.g., including multiple types of spacecrafts, such as spacecraft with different capabilities and/or constituent elements, spacecraft designed and/or constructed by different suppliers and/or in different countries, etc.). For example, the spacecraft 130 can include the same or different hub and/or same or different payloads of other spacecrafts.

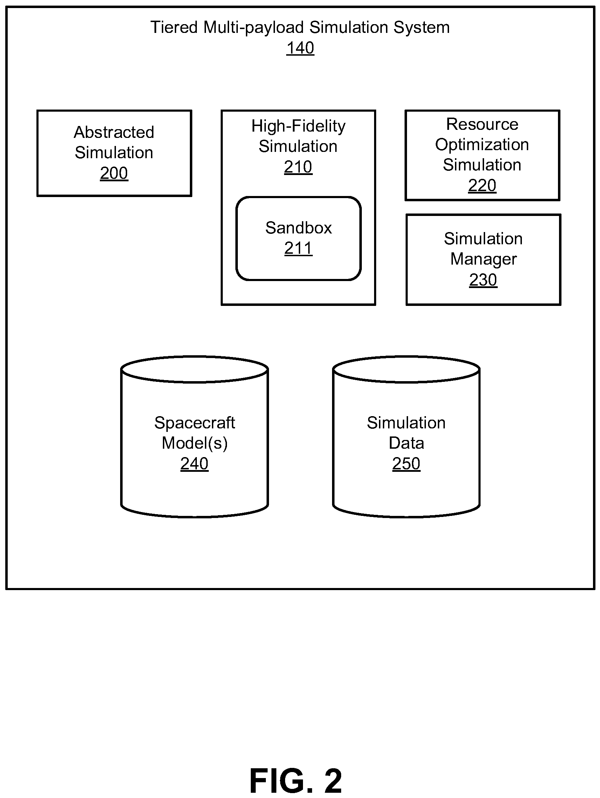

The tiered multi-payload simulation system 140 enables the validation of multiple payloads executed on a spacecraft using a sequence of simulations. The simulations may validate the functionality of payloads (e.g., one or more entity applications) individually and/or in various combinations to determine a set of payloads that operate on a spacecraft without interfering with one another. For example, the tiered multi-payload simulation system 140 may allow entities to simulate their entity applications using their own copies of the virtualized spacecraft hardware and subsequently, the tiered multi-payload simulation system 140 may simulate the entity applications together to determine an optimal time to allow each entity application to share resources aboard the spacecraft. Functions of the tiered multi-payload simulation system 140 are further described in the description of FIG. 2.

The network 150 may serve to communicatively couple the AI system 110 and the one or more client device 120. In some embodiments, the network 150 includes any combination of local area and/or wide area networks, using wired and/or wireless communication systems. The network 150 may use standard communications technologies and/or protocols. For example, the network 150 includes communication links using technologies such as Ethernet, 802.11, worldwide interoperability for 4G, 5G, X band, Ka band, UHF band, etc. Examples of networking protocols used for communicating via the network 110 include multiprotocol label switching (MPLS), transmission control protocol/Internet protocol (TCP/IP), hypertext transport protocol (HTTP), simple mail transfer protocol (SMTP), and file transfer protocol (FTP). Data exchanged over the network may be represented using any suitable format, such as hypertext markup language (HTML) or extensible markup language (XML). In some embodiments, all or some of the communication links of the network 150 may be encrypted using any suitable technique or techniques.

### Tiered Multi-Payload Simulation System

FIG. 2 is a block diagram of the tiered multi-payload simulation system 140 of FIG. 1, in accordance with one embodiment. The tiered multi-payload simulation system 140 may include one or more databases such as a database 250 for simulation data and a database 240 for one or more spacecraft models. The tiered multi-payload simulation system 140 may include software modules such as an abstracted simulation 200, a high-fidelity simulation 210, a resource optimization simulation 220, and a simulation manager 230. The tiered multi-payload simulation system 140 may have alternative configurations than shown in FIG. 2, including for example different, fewer, or additional components. For example, although not depicted, the tiered multi-payload simulation system 140 may include a software module for updating the spacecraft model(s) 240. As another example, the tiered multi-payload simulation system 140 may include a database storing entity profiles and histories of requests provided by entities and specifying requested spacecraft resources.

Different components of the tiered multi-payload simulation system 140 may be used to validate payloads before the payloads are executed during an orbital payload rideshare mission. In some embodiments, the abstracted simulation 200, the high-fidelity simulation 210, and the resource optimization simulation 220 are used in a sequence to validate the payloads and optimize an assignment of payloads to one or more spacecrafts. In one example of a three-tiered simulation process, client devices of entities requesting resources aboard a spacecraft may access the abstracted simulation 200 to perform an initial simulation of their payload (e.g., a software application of the entity or an "entity application"). In a second simulation following the first simulation with the abstracted simulation 200, the tiered multi-payload simulation system 140 may receive the simulated payloads from the client devices and use the high-fidelity simulation 210 to verify the operability of the simulated payloads against a more complete series of checks associated with the high-fidelity simulation 210. Third and finally, the tiered multi-payload simulation system 140 may apply the resource optimization simulation 220 to the payloads previously simulated by the high-fidelity simulation 210. This final simulation can enable the tiered multi-payload simulation system 140 to determine an optimize the assignment of payloads to spacecrafts based on the resource needs of each payload. The tiered simulation sequence can enable payloads from different entities to coexist on the same spacecraft without interfering with one another during the orbital payload rideshare mission.

The abstracted simulation 200 is used by entities to validate operability of entity applications with applications of a spacecraft. The abstracted simulation 200 may be an abstracted model of the spacecraft that omits certain portions of the software that is executed aboard the spacecraft during operation (e.g., flight code). The abstracted simulation 200 can include virtualized hardware of the spacecraft. The abstracted simulation 200 may serve as a check that the interfaces between the entity application and the software native to the spacecraft are working interfaces. The abstracted simulation 200 can save bandwidth and memory resources due to its smaller size relative to the high-fidelity simulation 210. An entity's client device does not necessarily need to download and store a larger simulation model (e.g., the high-fidelity simulation 210) to perform tests to verify that its entity application would be compatible with a particular spacecraft. Moreover, the abstracted simulation 200 can increase the efficiency of the testing process for an entity by allowing the entity to iterate on the design of their entity application flexibly rather than restrict the entity to iterating only after being able to access a copy of the high-fidelity simulation 210 at a secured site (e.g., the spacecraft operator's facility), which can be time and cost consuming (e.g., for entities who cannot travel easily to the spacecraft operator's facility).

The abstracted simulation 200 can include one or more API checks that validate an entity application's functionality and compatibility with spacecraft software and/or hardware. The abstracted simulation 200 may output API-level messages in the same format as messages output by the high-fidelity simulation 210 or the flight code executed during operation of the spacecraft. For example, the API-level message may be output by the abstracted simulation 200 in response to a call by an entity application to software managing a camera on a spacecraft. API-level messages may be limited to resources of a spacecraft needed by an entity according to an entity's envelope. For example, API checks by the abstracted simulation 200 may include messages in a format of messages that would be output by communication elements for transmitting data from a spacecraft to ground control elements. These messages may be included in response to an entity's envelope requesting communication elements for the entity's mission objective.

The API checks applied by the abstracted simulation 200 may simulate a duration of time taken by an entity application in performing a function. For example, an entity application may request spacecraft resources to take photos for monitoring weather on Earth, and to assist in the validation of the entity application, the abstracted simulation 200 simulates a duration of time needed to receive a request from the entity application to take a photo, a duration of time needed for a camera of the spacecraft to take the photo, and other durations of time associated with photographing the earth for monitoring weather. The abstracted simulation 200 may use log data from previous missions to estimate durations of time for simulating time delays for API checks.

The API checks may include pseudodata or predefined data. For example, the abstracted simulation 200 may generate an API-level message that is formatted to include image data, but the abstracted simulation 200 may generate a predefined image (e.g., taken by the spacecraft from a previous mission) to include in the message. The abstracted simulation 200 may determine the predefined data to present to a client device of an entity during abstracted simulation based on an entity's envelope. For example, the abstracted simulation 200 may determine to provide infrared images of cloud cover based on an envelope requesting an infrared camera during thunderstorms to determine intensity of the storm based on temperature of the cloud cover. In another example, the abstracted simulation 200 may identify a request in an entity's envelope requesting camera resources for weather imaging, and in response, the abstracted simulation 200 may determine to provide a variety of images of weather patterns (e.g., cloudy images and clear images). The abstracted simulation 200 may determine tailored simulation data to provide an entity's client device based on previous missions and associated entity envelopes. For example, the abstracted simulation 200 may use a model to determine a correlation between requests specified within an envelope and data captured by sensors to satisfy those requests.

The tiered multi-payload simulation system 140 may provide a client device of an entity access to the abstracted simulation 200. The tiered multi-payload simulation system 140 may provide a client device authorization to access a remote copy of the abstracted simulation 200 (e.g., a cloud copy of the abstracted simulation 200). In some embodiments, the tiered multi-payload simulation system 140 may provide a copy of the abstracted simulation 200 to a client device for download.

The high-fidelity simulation 210 verifies that an entity application can operate on a spacecraft using a different version of the spacecraft's flight code than used by the abstracted simulation 200. In some embodiments, the high-fidelity simulation 210 may include more of the flight code than the version used by the abstracted simulation 200. For example, the high-fidelity simulation 210 may be a byte-for-byte copy of the flight code. The high-fidelity simulation 210 may be used by a spacecraft operator (i.e., rather than at a client device of an entity). Client devices of entities may be prohibited from access the high-fidelity simulation 210 while being permitted to access the abstracted simulation 200.

The high-fidelity simulation 210 may be used by a spacecraft operator to validate that two or more entity applications can be executed together (in sequence or in parallel) on a spacecraft without interfering with one another. For example, a first entity application and a second entity application may be simulated together using the high-fidelity simulation 210 to validate that both entity applications can perform desired mission objections. The first entity application may be a research application (e.g., its objective is collecting water information of Earth) and the second entity application may be a mapping application (e.g., its objective is collecting land surface images of Earth). The high-fidelity simulation system 210 may simulate execution of both applications to confirm sufficient software and hardware resources are available for completing both mission objectives. For example, the high-fidelity simulation system 210 may verify that the camera(s) on the spacecraft are available to collect images for both applications at appropriate times indicated by the envelopes provided by respective entities.

The high-fidelity simulation 210 may use a model to determine a likelihood that two or more entity applications will interfere with one another based on operating parameters that indicate the context of the payloads operating on a spacecraft. Examples of operating parameters include a number of entity applications being executed aboard a spacecraft, the types and numbers of resources on the spacecraft, the requests specified in envelopes provided by entities, any suitable parameter related to the operation of payloads aboard a spacecraft, or a combination thereof. The model may be a machine learning model. The model can be trained on data collected from previous orbital payload rideshare missions that have functioned successfully and/or unsuccessfully (e.g., positive and/or negative training sets). The tiered multi-payload simulation system 140 may generate an aggregate representation of data collected from previous missions (e.g., a vector of the historical data). Unsuccessful missions may be indicated by errors output during rideshare mission operation and/or entity feedback of undesired results (e.g., image data failed to depict desired subject). Similarly, successful missions may be indicated by a lack of errors and/or entity feedback of desired results. Although not depicted, the tiered multi-payload simulation system 140 may include a training software module for training and updating the model to determine a likelihood that two or more entity applications will interfere with one another.

The high-fidelity simulation 210 may include a sandbox environment 211 in which the high-fidelity simulation 210 simulates one or more entity applications. The sandbox environment 211 enables a spacecraft operator to observe the behavior of entity applications in a secured environment. The entity applications may be developed wholly by a third-party entity with limited involvement by the spacecraft operator, where the extent of involvement may be providing access to the abstracted simulation 200 for initial software development. Because the spacecraft operator may be relatively unaware of what functions the entity applications can perform, the tiered multi-payload simulation system 140 affords the spacecraft operator increased assurance via the sandbox environment 211 that the entity applications will be secured and contained when the spacecraft operator simulates it for the first time using the high-fidelity simulation 210.

The high-fidelity simulation 210 may include a multilayer system of checks to identify commands from an entity application that instruct an element external to the entity application (e.g., spacecraft hardware or software) and determine whether the entity application has authorization to make such commands. For example, the high-fidelity simulation 210 determines that an entity application is outputting a command to slew the spacecraft and in response, the high-fidelity simulation 210 accesses a data structure containing authorization settings indicating which spacecraft resources the entity application is authorized to access. If the high-fidelity simulation 210 determines that the entity application has authorization to control the spacecraft's slew, the high-fidelity simulation 210 may continue to perform the simulation on the entity application. If the high-fidelity simulation 210 determines that the entity application does not have authorization, the high-fidelity simulation 210 may stop the simulation and/or generate a notification or log entry noting the unauthorized access, which may be provided to the client device of the entity for the entity to iterate on the design of their entity application. Alternatively, if the high-fidelity simulation 210 determines that the entity application does not have authorization, the high-fidelity simulation 210 may continue the simulation and monitor each command the entity application is sending out to control the spacecraft. Particularly, if the high-fidelity simulation 210 is utilizing the sandbox environment 211, continuing the simulation may enable the high-fidelity simulation 210 to observe any potential malicious activity within the secured bounds of the sandbox environment 211.

The resource optimization simulation 220 can optimize conditions to determine an operating scheme for the entity applications assigned to a given spacecraft. Examples of these operating conditions may include temporal specifications, spatial specifications, asset specifications, any suitable condition in which a service request may be fulfilled, or a combination thereof. For example, the resource optimization simulation 220 can determine that an optimal time to execute a first entity application is after executing a second entity application in response to determining that executing the second entity application caused a hardware element needed by the first entity application to be oriented in a desired position. In another example, the resource optimization simulation 220 determines one location to fulfill requests from multiple entity applications in response to determining the entity applications are requesting similar image data that can be provided at that location. An operating scheme may be a plan executed by a hub or other controller aboard the spacecraft 130 to manage and fulfill service requests by the payloads aboard the spacecraft 130.

In some embodiments, the resource optimization simulation 220 determines an operating scheme based on a performance metric associated with executing a payload (e.g., an entity application) that was determined during validation using the high-fidelity simulation 210. For example, the tiered multi-payload simulation system 140 determines a first power consumption performance metric associated with executing a first entity application and a second power consumption performance metric associated with executing a second entity application. The resource optimization simulation 220 determines, based on the first and second power consumption performance metrics, that the two entity applications cannot be executed at the same time aboard a single spacecraft. That is, the resource optimization simulation 220 may determine, based on metrics from the simulated missions, at least one common time at which two or more missions can be executed.

The resource optimization simulation 220 can determine assignments of entity applications to different spacecrafts based on spacecraft resources and/or existing entity applications already assigned to spacecrafts. For example, the resource optimization simulation 220 can assign a first entity application to a first spacecraft instead of a second spacecraft based on the availability of a sensor that the second spacecraft is equipped with but is already fully allocated to existing entity applications assigned to the second spacecraft. The resource optimization simulation 220 may perform a multi-objective optimization to determine an assignment of payloads to spacecrafts. The resource optimization simulation 220 may evaluate an optimal assignment as a dynamic constraint satisfaction problem. The optimization may be performed using a combination of heuristics and combinatorial search methods. The resource optimization simulation 220 may determine assignments for as many requests as possible (e.g., for highest priority requests), determining requests that maximize an overall objective function defined over the request assignment space (e.g., defined based on request specifications, aspects of the users and/or spacecraft, etc.), or determining assignments for any other suitable subset of requests.

In some embodiments, the resource optimization simulation 200 may consider modifications to requests provided by entities in envelopes. An entity may specify in the envelope provided to the tiered multi-payload simulation system 140 that their request may be modified within a specified degree of flexibility (e.g., requested time durations for using a requested asset may be modified +/-10% of requested duration). In response to identifying that an entity has authorized potential modifications, the resource optimization simulation 200 may automatically iteratively simulate through a set of potential modifications to an entity's envelope to determine one or more alternative envelope configurations that result in interoperability among payloads assigned to a spacecraft that do not interfere with one another.

Additionally, or alternatively, the resource optimization simulation 200 may propose modifications to an entity based on their envelope. The resource optimization simulation 200 may determine that a request in an envelope is overly restrictive (e.g., specifications that, if relaxed, could enable determination of additional assignments of payloads to spacecrafts or allocation of spacecraft resources to the entity). The resource optimization simulation 200 may suggest possible resolutions to the entity based on the overly restrictive specifications. For example, the resource optimization simulation 200 may determine that an entity application cannot operate at a requested frequency due to a conflict with another entity application for the same spacecraft resource. In response, the resource optimization simulation 200 may iterate through potential alternative frequencies, simulating the combination of entity applications using the alternative frequencies of operating the entity application. The resource optimization simulation 200 may determine a set of recommended frequencies to provide to the client device of the entity for review. The resource optimization simulation 200 may then receive an authorization by the entity from the client device to proceed with one of the recommended frequencies.

The resource optimization simulation 220 can model spacecrafts to optimize assignment of entity application to spacecrafts. These spacecraft models may be stored in the spacecraft model(s) database 240. For example, the resource optimization simulation 220 may apply a spacecraft model of the model(s) 240 to determine that a combination of entity applications is consuming more power resources than the spacecraft has available. In another example, the resource optimization simulation 220 may apply a spacecraft model to determine that a trajectory of the spacecraft is not compatible with a desired communication request by an entity application to send information to a ground station element that is not located at an appropriate location (e.g., spacecraft is not within the ground station's line of sight) along the trajectory.

The simulation manager 230 may update models of the tiered multi-payload simulation system 140 and determine when an update to a simulation of the tiered multi-payload simulation system 140 is needed. The simulation manager 230 may use data collected from missions to determine when to update the simulations. For example, the simulation manager 230 may access log data to identify that a first entity application was unable to capture an image at a desired location because a second entity application interfered in a manner unaccounted for in the existing high-fidelity simulation 210. The simulation manager 230 may generate a notification flagging to the spacecraft operator that the high-fidelity simulation 210 should be updated to account for the interference. In some embodiments, the simulation manager 230 may update the spacecraft model(s) 240 based on information collected during missions. For example, the simulation manager 230 may receive data from a spacecraft indicative of its operating physics (e.g., temperature and/or power consumption of certain hardware elements) and a corresponding model may be updated (e.g., a generic thermal model).

The spacecraft model(s) 240 enable the tiered multi-payload simulation system 140 to simulate spacecrafts (e.g., hardware components of spacecrafts) in a given operating environment (e.g., simulating orbit dynamics influencing the spacecraft, simulating power consumption within the spacecraft, etc.). The spacecraft model(s) 240 may simulate components of a spacecraft such as communication elements (e.g., antenna, communication links, etc.), a hub (e.g., interface modules), power components (e.g., battery, solar panels, etc.), sensors (e.g., cameras, inertial measurement units (IMUs), Global Positioning System (GPS) receivers, star trackers, etc.), actuators (e.g., propulsion and trajectory control mechanisms, reaction wheels, etc.), and other electrical or mechanical components of the spacecraft.

The spacecraft model(s) 240 may simulate operating physics of the spacecraft and/or the environment in which the spacecraft will travel. In an example of models for simulating operating physics, the spacecraft model(s) 240 may include isothermal and generic thermal models, power consumption models, rigid body and gyrostat dynamics, and various types of orbit simulations. In an example of models for simulating the environment, the spacecraft model(s) 240 may include disturbance simulations, an ephemeris, and/or gravity modeling. In some embodiments, the spacecraft model(s) 240 may include models of ground control elements and interactions with the spacecraft.

The simulation data 250 may include records of simulation inputs (e.g., envelopes specified by entities) and results (e.g., performance metrics like a number of times an entity's service request was successfully fulfilled in the simulation). The tiered multi-payload simulation system 140 may access the simulation data 250 to provide feedback to entities' client devices (e.g., recommendations to modify envelopes). The simulation data 250 may also include predefined data to provide in the abstracted simulation 200. For example, the simulation data 250 may include images previously captured by spacecraft cameras, which may be provided to a client device of an entity whose service request is related to taking similar images.

### Process for Simulating Missions Using the Tiered Multi-payload Simulation System

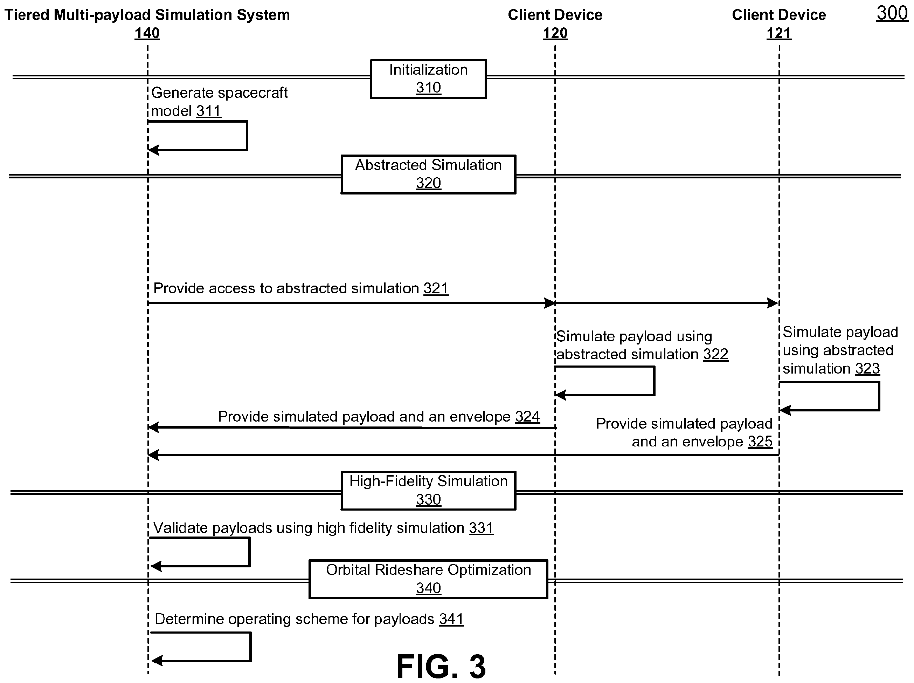

FIG. 3 is a flowchart illustrating a process 300 for simulating multiple payloads for an orbital payload rideshare mission, in accordance with one embodiment. The process 300 includes an initialization stage 310 (before simulation), an abstracted simulation stage 320, a high-fidelity simulation 330 stage, and an orbital rideshare optimization 340 stage. The orbital rideshare optimization stage 340 includes a simulation of payloads using models generated during the initialization stage 310. In some embodiments, the tiered multi-payload simulation system 140 performs operations of the process 300 in parallel or in different orders, or may perform different steps. For example, the process 300 may include an additional step of determining a modification to a received envelope and providing the modification to a client device for approval to incorporate into an orbital payload rideshare mission.

In an initialization stage 310, the tiered multi-payload simulation system 140 generates a spacecraft model 311. In one embodiment, the tiered multi-payload simulation system 140 receives, from a spacecraft operator, specifications of a spacecraft (e.g., identifiers of actuators, sensors, computational components, etc. on the spacecraft) and retrieve from the spacecraft model(s) database 240 one or more model(s) corresponding to the specifications of the spacecraft. The tiered multi-payload simulation system 140 may also retrieve from the database 240 models of environment. In response to determining that there is no prior existing model of a component of the spacecraft, the tiered multi-payload simulation system 140 may retrieve an existing model of another component that is similar to the component of the spacecraft. In response to determining that there is no prior existing model of the operating physics of the particular spacecraft that the operator has defined, the tiered multi-payload simulation system 140 may determine a similar spacecraft (e.g., comparing specifications of the operator's spacecraft and previously modeled spacecrafts) and use an existing model of the similar spacecraft. The tiered multi-payload simulation system 140 may generate a spacecraft model using a combination of the retrieved model(s).

In an abstracted simulation stage 320, the tiered multi-payload simulation system 140 provides 321 client devices 120 and 121 access to an abstracted simulation of the spacecraft 130 (e.g., the abstracted simulation 200). In one example, a first entity is associated with a natural disaster response agency and is developing an entity application to track wildfires over a particular geographic region (e.g., North America). A second entity is associated with a climate research organization and is developing an entity application to study changes to Earth's oceans over time (e.g., sea surface temperatures, sea levels, etc.). The client device 120 may be associated with the first entity and the client device 121 may be associated with t he second entity. The first and second entities may receive permission from the tiered multi-payload simulation system 140 to download copies of the abstracted simulation 200 at their respective client devices.

The client devices 120 and 121 simulate 322 and 323 their respective payloads using the copies of the abstracted simulation provided by the tiered multi-payload simulation system 140. The first and second entities may then iteratively develop their entity applications using their local copies of the abstracted simulation 200. The first and second entities may test their entity applications against the API checks of the abstracted simulation 200, verifying that the interfaces between their application and the desired resources of the spacecraft are operable. For example, simulations of a first entity application at the client device 120 includes the abstract simulation 200 generating API-level messages in response to receiving an envelope requesting camera sensors under a trigger condition that the spacecraft is positioned over North America. The generated API-level messages may include predefined images of wildfires previously taken from the spacecraft or other spacecrafts. The API checks may also simulate capturing images periodically and time durations needed to periodically capture these images.

The tiered multi-payload simulation system 140 receives 324 a payload and an envelope provided by the client device 120 and receives 325 a payload and an envelope provided by the client device 121. Following the previous example, the client device 120 may provide a payload for tracking wildfires that has been simulated using the abstracted simulation 200. The client device 120 may provide an envelope defining a request for the wildfire tracking service. For example, the envelope may specify that a particular imaging sensor is needed, spatial specifications corresponding to where the sensor is needed, temporal specifications corresponding to when the sensor is needed, any suitable parameter for performing the requested service, or combination thereof. Similarly, the client device 121 may provide a payload for monitoring data about Earth's oceans that has been simulated using the abstracted simulation 200. The client device 121 may provide an envelope defining a request for the ocean monitoring service. For example, the envelope may specify that an infrared imaging sensor and an altimeter radar are needed, spatial specifications for when the two hardware elements are needed (which may be different for the different hardware elements), temporal specifications, etc.

In a high-fidelity simulation stage 330, the tiered multi-payload simulation system 140 validates 331 payloads using the high-fidelity simulation 210. The high-fidelity simulation 210 may be a complete reproduction of the spacecraft's software to simulate the payloads provided by the client devices 120 and 121. Using the high-fidelity simulation 210 enables the tiered multi-payload simulation system 140 to verify that each individual payload does indeed operate compatibly with the spacecraft. This verification may be necessary because the spacecraft operator is not necessarily the entity, and thus, cannot guarantee the entity has verified their payload before providing the payload to the spacecraft operator for incorporation onto the operator's spacecraft. Because the operator cannot guarantee that the behavior of a given entity application is not malicious, the high-fidelity simulation 210 may simulate the entity application in the sandbox environment 211 to improve security for the system on which the high-fidelity simulation 210 is executed.

Validation 331 of the payloads may also include a multilayer system of checks to identify commands from an entity application that instructs an element external to the application. Following the earlier example, the high-fidelity simulation 210 may apply the checks to identify that the first entity application for tracking wildfires is instructing a camera sensor to capture an image as the satellite is over North America. The high-fidelity simulation 210 may then determine whether the first entity application has permission to instruct the camera sensor (e.g., using a lookup table of permissions given to entities for accessing certain components of the spacecraft).

Finally, in an orbital rideshare optimization stage 340, the tiered multi-payload simulation system 140 determines 341 an operating scheme for the payloads. The operating scheme may define an order for executing payloads, a time duration for which an entity-specific payload is allocated a hardware element of the spacecraft, any suitable condition for fulfilling requests from multiple entities aboard one spacecraft, or a combination thereof. The tiered multi-payload simulation system 140 may use the resource optimization simulation 220 to determine the operating scheme. Following the earlier example, the resource optimization simulation 220 may determine a scheme in which the first and second entity applications may be executed. The determination may treat the two entity applications as independent due to the lack of overlap of requested assets (i.e., different sensors needed for the different service requests) and trigger conditions for using the requested assets (e.g., images taken of wildfires in North America are at different locations than infrared images taken of sea surface temperatures). In another example, the resource optimization simulation 220 may determine an operating scheme to execute an entity application that changes the trajectory of the spacecraft towards an area before executing a different entity application that is requesting images of the area.

In determining 341 the operating scheme, the tiered multi-payload simulation system 140 may determine synergies in servicing both the first and second entities' requests. For example, the tiered multi-payload simulation system 140 may simulate a weather tracking mission and an ocean monitoring mission together and determine that both entity applications request an infrared camera sensor. The tiered multi-payload simulation system 140 may capture an image and provide the same image to both entity applications to service their requests without duplicating processing resources or storage expended.

### Additional Considerations

The foregoing description of the embodiments has been presented for the purpose of illustration; it is not intended to be exhaustive or to limit the patent rights to the precise forms disclosed. Persons skilled in the relevant art can appreciate that many modifications and variations are possible in light of the above disclosure.

The present disclosure may be provided as a computer program product, or software, that may include a machine-readable medium having stored thereon instructions, which may be used to program a computer system (or other electronic devices) to perform a process according to the present disclosure. A machine-readable medium includes any mechanism for storing information in a form readable by a machine (e.g., a computer). For example, a machine-readable (e.g., computer-readable) medium includes a machine (e.g., a computer) readable storage medium such as a read only memory ("ROM"), random access memory ("RAM"), magnetic disk storage media, optical storage media, flash memory devices, etc.

Embodiments may also relate to an apparatus for performing the operations herein. This apparatus may be specially constructed for the required purposes, and/or it may comprise a general-purpose computing device selectively activated or reconfigured by a computer program stored in the computer. Such a computer program may be stored in a non-transitory, tangible computer readable storage medium, or any type of media suitable for storing electronic instructions, which may be coupled to a computer system bus. Furthermore, any computing systems referred to in the specification may include a single processor or may be architectures employing multiple processor designs for increased computing capability.

The algorithms and displays presented herein are not inherently related to any particular computer or other apparatus. Various other systems may be used with programs in accordance with the teachings herein, or it may prove convenient to construct a more specialized apparatus to perform the method. In addition, the present disclosure is not described with reference to any particular programming language. It will be appreciated that a variety of programming languages may be used to implement the teachings of the disclosure as described herein.

Embodiments may also relate to a product that is produced by a computing process described herein. Such a product may comprise information resulting from a computing process, where the information is stored on a non-transitory, tangible computer readable storage medium and may include any embodiment of a computer program product or other data combination described herein.

As used herein any reference to "one embodiment" or "an embodiment" means that a particular element, feature, structure, or characteristic described in connection with the embodiment is included in at least one embodiment. The appearances of the phrase "in one embodiment" in various places in the specification are not necessarily all referring to the same embodiment. Where values are described as "approximate" or "substantially" (or their derivatives), such values should be construed as accurate +/- 10% unless another meaning is apparent from the context. From example, "approximately ten" should be understood to mean "in a range from nine to eleven."

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of the "a" or "an" are employed to describe elements and components of the embodiments herein. This is done merely for convenience and to give a general sense of the invention. This description should be read to include one or at least one and the singular also includes the plural unless it is obvious that it is meant otherwise.

Finally, the language used in the specification has been principally selected for readability and instructional purposes, and it may not have been selected to delineate or circumscribe the patent rights. It is therefore intended that the scope of the patent rights be limited not by this detailed description, but rather by any claims that issue on an application based hereon. Accordingly, the disclosure of the embodiments is intended to be illustrative, but not limiting, of the scope of the patent rights, which is set forth in the following claims.

Further embodiments of the present invention may be summarized as follows. Any of these embodiments can be claimed in a separate claim, e.g. by substituting the word "Embodiment" by "Claim", in particular in the order as mentioned below and/or in any combination with any embodiment described above or with any of the features of the attached claims:
Embodiment 1. A method comprising:
   receiving, for each of a plurality of client devices, an envelope comprising simulation parameters for simulating a payload, wherein the payload was previously simulated using an abstracted simulation including a subset of resources for simulating a spacecraft;
   validating the payloads using a high-fidelity simulation and the received envelopes; and responsive to validating the payloads, determining an operating scheme for the payloads for an orbital rideshare mission of the spacecraft.
Embodiment 2. The method of embodiment 1, wherein determining the operating scheme for the payloads for the orbital rideshare mission of the spacecraft comprises:
   simulating missions associated with the payloads; and
   determining, based on the simulated missions, at least one common time at which two or more missions can be executed.
Embodiment 3. The method of embodiment 1 or 2, wherein determining the operating scheme for the payloads for the orbital rideshare mission of the spacecraft comprises:
   allocating, based on one or more of a location of the spacecraft or a trajectory of the spacecraft, hardware components to the payloads.
Embodiment 4. The method of any of embodiments 1 to 3, wherein the abstracted simulation includes API-level messages having a same format used for the high-fidelity simulation.
Embodiment 5. The method of any of embodiments 1 to 4, wherein the payload is validated in a sandbox environment.
Embodiment 6. The method of any of embodiments 1 to 5, wherein validating the payloads using the high-fidelity simulation comprises:
   for each payload:
   identifying a command output by the payload comprises an instruction for operating a hardware element of the spacecraft; and
   in response to applying a plurality of checks to the command, determining whether an entity associated with the payload is authorized to output the command.
Embodiment 7. The method of any of embodiments 1 to 6, wherein the simulation parameters include one or more of: a position of an object in an environment, a weather condition, a target performance metric, a temporal specification, a spatial specification of the spacecraft, or asset specification.
Embodiment 8. The method of any of embodiments 1 to 7, further comprising: generating the high-fidelity simulation using one or more of a payload model, a spacecraft platform model, a payload hub model, or a ground station model.
Embodiment 9. The method of any of embodiments 1 to 8, further comprising: determining a performance metric associated with executing the payload during the validation,
   wherein the operating scheme is determined based on the performance metric.
Embodiment 10. The method of any of embodiments 1 to 9, further comprising:
   in response to determining a simulation parameter of a received envelope is overly restrictive: modifying the simulation parameter, and
   simulating, using the modified simulation parameter, missions associated with the payloads; and
   providing to a client device a recommendation to modify the simulation parameter based on the simulated missions.
Embodiment 11. A system comprising:
   one or more processors; and
   a non-transitory computer readable storage medium storing executable instructions that, when executed by the one or more processors, cause the one or more processors to perform steps comprising:
      receiving, for each of a plurality of client devices, an envelope comprising simulation parameters for simulating a payload, wherein the payload was previously simulated using an abstracted simulation including a subset of resources for simulating a spacecraft;
      validating the payloads using a high-fidelity simulation and the received envelopes; and responsive to validating the payloads, determining an operating scheme for the payloads for an orbital rideshare mission of the spacecraft.
Embodiment 12. The system of embodiment 11, wherein determining the operating scheme for the payloads for the orbital rideshare mission of the spacecraft comprises:
   simulating missions associated with the payloads; and
   determining, based on the simulated missions, at least one common time at which two or more missions can be executed.
Embodiment 13. The system of embodiment 11 or 12, wherein determining the operating scheme for the payloads for the orbital rideshare mission of the spacecraft comprises:
   allocating, based on one or more of a location of the spacecraft or a trajectory of the spacecraft, hardware components to the payloads.
Embodiment 14. The system of any of embodiments 11 to 13, wherein the abstracted simulation includes API-level messages having a same format used for the high-fidelity simulation.
Embodiment 15. The system of any of embodiments 11 to 14, wherein validating the payloads using the high-fidelity simulation comprises:
   for each payload:
   identifying a command output by the payload comprises an instruction for operating a hardware element of the spacecraft; and
   in response to applying a plurality of checks to the command, determining whether an entity associated with the payload is authorized to output the command.
Embodiment 16. A non-transitory computer readable storage medium storing executable instructions that, when executed by one or more processors, cause the one or more processors to perform steps comprising:
   receiving, for each of a plurality of client devices, an envelope comprising simulation parameters for simulating a payload, wherein the payload was previously simulated using an abstracted simulation including a subset of resources for simulating a spacecraft;
   validating the payloads using a high-fidelity simulation and the received envelopes; and
   responsive to validating the payloads, determining an operating scheme for the payloads for an orbital rideshare mission of the spacecraft.
Embodiment 17. The non-transitory computer readable storage medium of embodiment 16, wherein determining the operating scheme for the payloads for the orbital rideshare mission of the spacecraft comprises:
   simulating missions associated with the payloads; and
   determining, based on the simulated missions, at least one common time at which two or more missions can be executed.
Embodiment 18. The non-transitory computer readable storage medium of embodiment 16 or 17, wherein determining the operating scheme for the payloads for the orbital rideshare mission of the spacecraft comprises:
   allocating, based on one or more of a location of the spacecraft or a trajectory of the spacecraft, hardware components to the payloads.
Embodiment 19. The non-transitory computer readable storage medium of any of embodiments 16 to 18, wherein the abstracted simulation includes API-level messages having a same format used for the high-fidelity simulation.
Embodiment 20. The non-transitory computer readable storage medium of any of embodiments 16 to 19, wherein validating the payloads using the high-fidelity simulation comprises:
   for each payload:
   identifying a command output by the payload comprises an instruction for operating a hardware element of the spacecraft; and
   in response to applying a plurality of checks to the command, determining whether an entity associated with the payload is authorized to output the command.

In an embodiment, a system may comprise: one or more processors; and a non-transitory computer readable storage medium storing executable instructions that, when executed by the one or more processors, cause the one or more processors to perform a method according to or within any of the above mentioned embodiments.

In an embodiment, a non-transitory computer readable storage medium may store executable instructions that, when executed by one or more processors, cause the one or more processors to perform a method according to or within any of the above mentioned embodiments.

In an embodiment, a computer program product, preferably comprising a computer-readable non-transitory storage media, may be operable when executed on a data processing system to perform a method according to or within any of the above mentioned embodiments.

## Claims

1. A method comprising:
receiving, for each of a plurality of client devices, an envelope comprising simulation parameters for simulating a payload, wherein the payload was previously simulated using an abstracted simulation including a subset of resources for simulating a spacecraft;
validating the payloads using a high-fidelity simulation and the received envelopes; and
responsive to validating the payloads, determining an operating scheme for the payloads for an orbital rideshare mission of the spacecraft.

2. The method of claim 1, wherein determining the operating scheme for the payloads for the orbital rideshare mission of the spacecraft comprises:
simulating missions associated with the payloads; and
determining, based on the simulated missions, at least one common time at which two or more missions can be executed.

3. The method of claim 1 or 3, wherein determining the operating scheme for the payloads for the orbital rideshare mission of the spacecraft comprises:
allocating, based on one or more of a location of the spacecraft or a trajectory of the spacecraft, hardware components to the payloads.

4. The method of any of claims 1 to 3, wherein the abstracted simulation includes API-level messages having a same format used for the high-fidelity simulation.

5. The method of any of claims 1 to 4, wherein the payload is validated in a sandbox environment.

6. The method of any of claims 1 to 5, wherein validating the payloads using the high-fidelity simulation comprises:
for each payload:
identifying a command output by the payload comprises an instruction for operating a hardware element of the spacecraft; and
in response to applying a plurality of checks to the command, determining whether an entity associated with the payload is authorized to output the command.

7. The method of any of claims 1 to 6, wherein the simulation parameters include one or more of: a position of an object in an environment, a weather condition, a target performance metric, a temporal specification, a spatial specification of the spacecraft, or asset specification.

8. The method of any of claims 1 to 7, further comprising:
generating the high-fidelity simulation using one or more of a payload model, a spacecraft platform model, a payload hub model, or a ground station model.

9. The method of any of claims 1 to 8, further comprising:
determining a performance metric associated with executing the payload during the validation,
wherein the operating scheme is determined based on the performance metric.

10. The method of any of claims 1 to 9, further comprising:
in response to determining a simulation parameter of a received envelope is overly restrictive:
modifying the simulation parameter, and
simulating, using the modified simulation parameter, missions associated with the payloads; and
providing to a client device a recommendation to modify the simulation parameter based on the simulated missions.

11. A system comprising:
one or more processors; and
a non-transitory computer readable storage medium storing executable instructions that, when executed by the one or more processors, cause the one or more processors to perform a method according to any of claims 1 to 10.

12. A non-transitory computer readable storage medium storing executable instructions that, when executed by one or more processors, cause the one or more processors to perform a method according to any of claims 1 to 10.
